# EUROPEAN PATENT APPLICATION

(11) **EP 4 685 306 A1**
(43) Date of publication of application: **28.01.2026**
(21) Application number: 24774982.3
(22) Date of filing: 22.03.2024
(51) Int. Cl.: E04D 13/18, H02S 20/23, H10K 30/88, H10K 39/10

(54) **INSTALLATION STRUCTURE FOR PHOTOVOLTAIC POWER GENERATION SHEET**

(30) Priority: 23.03.2023 JP 2023046596
(71) Applicant: Sekisui Chemical Co., Ltd., Osaka-shi, Osaka 530-8565 (JP)
(72) Inventor: UNO, Tomohito, Osaka-shi, Osaka 530-8565 (JP); YOKOTA, Ibuki, Osaka-shi, Osaka 530-8565 (JP)
(74) Representative: Ter Meer Steinmeister & Partner
(86) International application number: PCT/JP2024/011188
(87) International publication number: WO 2024/195848

(57) **Abstract**

Provided is an installation structure for a photovoltaic power generation sheet that can be installed on an installation surface while inhibiting decrease in power generation efficiency in an installed state.

An installation structure 100 for a photovoltaic power generation sheet 1 includes a photovoltaic power generation sheet 1 having a power generation unit 7 in which a plurality of band-shaped power generation cells 12 extending in one direction are arranged in a direction orthogonal to the one direction, and an elongated mounting member 2 configured to mount the photovoltaic power generation sheet 1 to an installation surface 3 by pressing the photovoltaic power generation sheet 1 from above. In the mounting member 2, a longitudinal direction of the mounting member 2 intersects a longitudinal direction of the power generation cells 12.

## Description

### Technical Field

The present invention relates to an installation structure for a photovoltaic power generation sheet.

### Background Art

PTL 1 discloses an installation structure for a solar panel. The installation structure described in PTL 1 includes a fixing member and a reinforcing member fixed to a surface of a roof by adhesive or the like. One end portion of the solar panel is rotatably mounted to the fixing member via a hinge, and the other end portion is detachably fixed to the reinforcing member made of a magnetic material via a magnet. Thus, the solar panel is installed on the roof.

### Citation List

### Patent Literature

PTL 1: Japanese Patent Application Publication No. 2021-195846

### Summary of Invention

### Technical Problem

The solar panel described in PTL 1 is a solar cell processed into a plate shape, which is difficult to bend, and is generally installed on the roof using a mounting frame made of, for example, the fixing member and the reinforcing member. However, the mounting frame has a complex structure and is heavy. For this reason, when the solar panel described in PTL 1 is installed, the work of mounting the mounting frame requires a great deal of effort.

In recent years, photovoltaic power generation sheets using organic solar cells such as perovskite compounds have been widely used. A power generation unit of this type of photovoltaic power generation sheet is monolithic, with a plurality of band-shaped power generation cells arranged in a width direction thereof.

A photovoltaic power generation sheet is flexible, and thus, if there is a gap between the photovoltaic power generation sheet and an installation surface, or if the sheet is only partially fixed, it is likely to flap when installed due to the influence of wind or the like. In particular, since flexible photovoltaic power generation sheets are often large because of their light weight, and it has become clear in recent years that the problem of flapping has become more pronounced. Since photovoltaic power generation sheets have the characteristic that their power generation efficiency decreases due to vibration, it is required to inhibit flapping as much as possible.

Here, as a method for directly installing a photovoltaic power generation sheet on a surface of a roof, it is conceivable to fix the entire region of the photovoltaic power generation sheet to the surface of the roof, or to fix the entire periphery of a peripheral edge portion of the photovoltaic power generation sheet to the surface of the roof. However, with this method, when it is required to retrieve the photovoltaic power generation sheet, a flexible power generation portion of the photovoltaic power generation sheet is likely to bend when the photovoltaic power generation sheet is mounted to or detached from the surface of the roof. In this case, a stress may be concentrated on the power generation portion, which may cause damage to the power generation portion. Further, when a large photovoltaic power generation sheet is fixed, it is required to fix it more firmly than with a solar cell having a typical size in the related art, and thus damage is more likely to occur when the photovoltaic power generation sheet is retrieved.

On the other hand, it is also conceivable to cover the entire outer periphery of a photovoltaic power generation sheet with a frame-shaped frame member. However, when the entire outer periphery of the photovoltaic power generation sheet is covered with the frame-shaped frame member, power generation cells at both ends in the width direction among the plurality of power generation cells arranged in the width direction are shaded by the frame member over the entire length in a longitudinal direction thereof. In this type of photovoltaic power generation sheet, if even just one of the plurality of power generation cells is shaded over the entire length in the longitudinal direction, the power generation efficiency drops drastically. Further, since only the outer periphery of the photovoltaic power generation sheet is fixed, there is a problem that a sufficient fixing force cannot be obtained. In particular, since the photovoltaic power generation sheet is lightweight and flexible, deformation such as bulging is likely to occur in areas other than the outer peripheral portion when wind blows between the installation surface and the photovoltaic power generation sheet. In this case, a stress may concentrate at a boundary between a fixed part of the outer periphery and the bulge, causing damage to the photovoltaic power generation sheet, and deformation and vibration caused by, for example, wind blowing may also cause damage to the power generation cells.

An object of the present invention is to provide an installation structure for a photovoltaic power generation sheet that can be installed on an installation surface while inhibiting a decrease in power generation efficiency when installed.

### Solution to Problem

In order to achieve the above object, the present invention includes the subject matters described in the following Items.

Item 1. An installation structure for a photovoltaic power generation sheet including: a photovoltaic power generation sheet including a power generation unit in which a plurality of band-shaped power generation cells extending in one direction are arranged in a direction orthogonal to the one direction; and
an elongated mounting member configured to press down on the photovoltaic power generation sheet from above, thereby mounting the photovoltaic power generation sheet to an installation surface,
the mounting member being such that a longitudinal direction of the mounting member intersects a longitudinal direction of the power generation cells.

Item 2. The installation structure for a photovoltaic power generation sheet according to item 1, wherein
the installation surface is a roof surface having a slope, and
the photovoltaic power generation sheet is disposed so that the longitudinal direction of the power generation cells intersects a water flow direction on the roof surface.

Item 3. The installation structure for a photovoltaic power generation sheet according to item 2, wherein
the roof surface is included in an uneven roof configured so that protruding portions and recessed portions extending in the water flow direction are alternately arranged in a horizontal direction intersecting the water flow direction,
the photovoltaic power generation sheet is disposed so that the longitudinal direction of the power generation cells is aligned with the horizontal direction, and
the mounting member is disposed so that the longitudinal direction is along at least one protruding portion of the plurality of protruding portions and is mounted to a top portion of the protruding portion.

Item 4. The installation structure for a photovoltaic power generation sheet according to item 1, wherein
the installation surface is a roof surface having a slope, and the photovoltaic power generation sheet is disposed so that the longitudinal direction of the power generation cells is aligned with a water flow direction on the roof surface.

Item 5. The installation structure for a photovoltaic power generation sheet according to item 4, wherein
the installation surface is a roof surface of an uneven roof having a slope,
the uneven roof is configured so that protruding portions and recessed portions extending in the water flow direction are arranged alternately in a horizontal direction intersecting the water flow direction, and
the mounting member is disposed so that its longitudinal direction is aligned with the horizontal direction and is mounted to the protruding portions to straddle the plurality of protruding portions.

Item 6. The installation structure for a photovoltaic power generation sheet according to any one of items 1 to 5, wherein the longitudinal direction of the power generation cells is parallel to a longitudinal direction of the photovoltaic power generation sheet.

### Advantageous Effects of Invention

The installation structure for a photovoltaic power generation sheet of the above aspects according to the present invention has the advantage that it can be installed on the installation surface while inhibiting a decrease in power generation efficiency when installed.

### Brief Description of Drawings

Fig. 1 is an exploded perspective view of an installation structure for a photovoltaic power generation sheet according to an embodiment.
Fig. 2(A) is a cross-sectional view along a cross-section orthogonal to a lateral direction of the photovoltaic power generation sheet. Fig. 2(B) is an enlarged view of section B in Fig. 3(A). Fig. 2(C) is a cross-sectional view of a power generation unit along line D-D in Fig. 2(A).
Fig. 3 is a cross-sectional view of the installation structure for a photovoltaic power generation sheet according to the embodiment, along a cross-section orthogonal to a water flow direction.
Fig. 4 is a plan view of the installation structure for a photovoltaic power generation sheet according to the embodiment.
Fig. 5 is a plan view of an installation structure for a photovoltaic power generation sheet according to a modified example.
Fig. 6 is a plan view of an installation structure for a photovoltaic power generation sheet according to another modified example.
Fig. 7 is a cross-sectional view of an installation structure for a photovoltaic power generation sheet according to yet another modified example.

### Description of Embodiments

### Embodiment

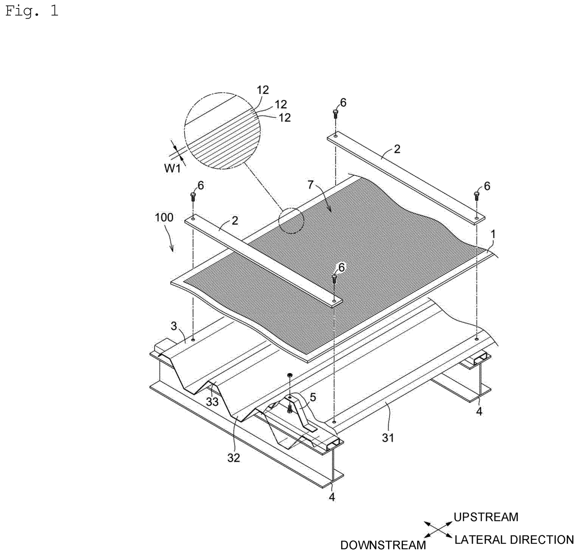

As shown in Fig. 1, an installation structure 100 for a photovoltaic power generation sheet 1 according to the present embodiment includes the photovoltaic power generation sheet 1 and a mounting member 2 for mounting the photovoltaic power generation sheet 1 to an installation surface 3. The photovoltaic power generation sheet 1 is a sheet material that receives sunlight and generates electricity. The photovoltaic power generation sheet 1 has one or more power generation units 7. As shown in Fig. 1, the power generation unit 7 is monolithic while band-shaped power generation cells 12 extending in one direction are disposed so that they are arranged in a width direction of the power generation cells 12. In the following, a structure that is monolithic may be referred to as a "monolithic structure".

The mounting member 2 is formed in an elongated shape extending in one direction. The mounting member 2 is fixed to the installation surface 3, and presses down on the photovoltaic power generation sheet 1 from above, and thus the photovoltaic power generation sheet 1 can be mounted to the installation surface 3. With the photovoltaic power generation sheet 1 and the mounting member 2 mounted to the installation surface 3, a longitudinal direction of the mounting member 2 intersects a longitudinal direction of the power generation cells 12 of the photovoltaic power generation sheet 1 and does not extend parallel to the longitudinal direction of the power generation cells 12.

In the installation structure 100 for the photovoltaic power generation sheet 1 configured in this manner, even if the photovoltaic power generation sheet 1 is mounted to the installation surface by the elongated mounting member 2 to cross a region inward from an outer edge thereof, only a part of the total length of the band-shaped power generation cells 12 is covered, and the entire length of the power generation cells 12 in the longitudinal direction is not shaded, and thus a decrease in power generation efficiency in each of the power generation cells 12 is reduced. In addition, the photovoltaic power generation sheet 1 can be pressed down by the elongated mounting member 2, which can inhibit flapping. Further, the photovoltaic power generation sheet 1 is not bonded to the installation surface 3, but is installed by pressing it from above with the mounting member 2, and thus its bending is also reduced when removed from the installation surface. As a result, according to the installation structure 100 for the photovoltaic power generation sheet 1 of the present embodiment, even if it is firmly fixed to the installation surface 3, stable power generation efficiency can be obtained.

The installation surface 3 mentioned here indicates a surface including a portion to which the photovoltaic power generation sheet 1 is mounted. Examples of a place including the installation surface 3 include a roof, a wall material, a floor material, a road, a cover for a sedimentation basin, a vinyl greenhouse, an automobile, an aircraft, a truck bed, a ship, and the like.

In the present embodiment, the installation surface 3 is described as a roof surface having a slope. In the roof surface, a direction along the slope is defined as a "water flow direction", and a direction intersecting the water flow direction is defined as a "horizontal direction". In the present embodiment, the "horizontal direction" is orthogonal to the water flow direction. Also, a direction orthogonal to the water flow direction and the horizontal direction is defined as a "vertical direction". In the water flow direction, a higher side is defined as an "upstream water side", and a lower side is defined as a "downstream water side".

Also, the term "plan view" here indicates viewing an object in the vertical direction. The term "parallel" here includes not only cases in which two lines, sides, faces, or the like do not intersect each other even when extended, but also cases in which an angle formed between two lines, sides, faces, or the like is within a range of 10°. In addition, the term "orthogonal" includes cases in which two lines, sides, faces, or the like intersect each other at an angle of 90°±10°.

Details of the installation structure 100 for the photovoltaic power generation sheet 1 according to the present embodiment will be described in detail below with reference to the drawings.

### Photovoltaic power generation sheet 1

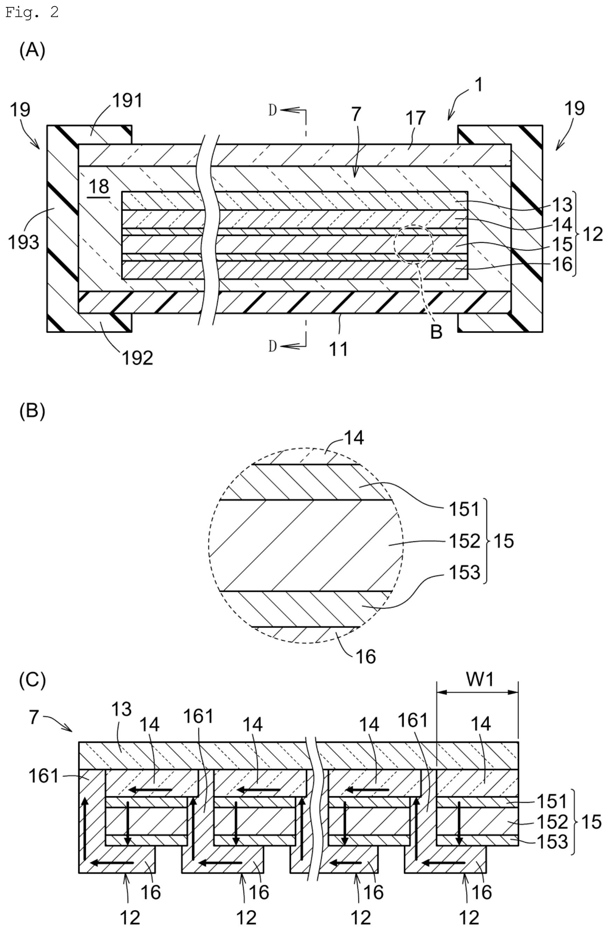

The photovoltaic power generation sheet 1 has a light receiving surface on at least one surface in a thickness direction thereof. The light receiving surface is a surface on which sunlight is incident. As shown in Fig. 2, the photovoltaic power generation sheet 1 includes a back sheet 11, at least one power generation unit 7, a barrier sheet 17 including the light receiving surface, a sealing layer 18, and a sealing edge material 19. The power generation unit 7 and the sealing layer 18 are disposed between the back sheet 11 and the barrier sheet 17. The sealing edge material 19 seals the entire length of an outer edge with a plurality of power generation units 7 and the sealing layer 18 disposed between the back sheet 11 and the barrier sheet 17. Sunlight incident on the barrier sheet 17 is incident on the power generation units 7 through the sealing layer 18.

As shown in Fig. 1, the photovoltaic power generation sheet 1 according to the present embodiment is formed in a rectangular shape in a plan view. In the present embodiment, the photovoltaic power generation sheet 1 has a longitudinal direction parallel to the water flow direction and a lateral direction parallel to the horizontal direction. However, the photovoltaic power generation sheet 1 may be installed so that the longitudinal direction is parallel to the horizontal direction and the lateral direction is parallel to the water flow direction. Also, the shape of the photovoltaic power generation sheet 1 is not limited to a rectangular shape in a plan view, and may be, for example, a square shape in a plan view, a substantially circular shape in a plan view, an elliptical shape in a plan view, a polygonal shape in a plan view, or the like.

The terms "sheet" and "sheet shape" used here indicate a shape in which a thickness of an object is 10% or less of the maximum length between outer edges in a plan view. If the shape in a plan view is rectangular, the "maximum length between outer edges in a plan view" indicates a length of its diagonal. Also, if the shape in a plan view is circular, the "maximum length between outer edges in a plan view" indicates a length of its diameter. The term "sheet shape" also includes a membrane shape, a foil shape, a film shape, and the like.

As described above, the photovoltaic power generation sheet 1 has flexibility. The term "having flexibility" used here indicates that an object has the property of being bendable. A bending strength of the photovoltaic power generation sheet 1 according to the present embodiment is not particularly limited, but is preferably 10 MPa or more, and more preferably 20 MPa or more. Also, the bending strength of the photovoltaic power generation sheet 1 is preferably 150 MPa or less, more preferably 50 MPa or less. In addition, the photovoltaic power generation sheet 1 may be defined by a bending modulus, which is preferably 100 MPa or more, and more preferably 500 MPa or more. On the other hand, the bending modulus of the photovoltaic power generation sheet 1 is preferably 10,000 MPa or less, more preferably 5,000 MPa or less. In the case of defining the photovoltaic power generation sheet 1 by the bending modulus, the bending strength does not have to be within the above range. The bending strength and the bending modulus of the photovoltaic power generation sheet 1 are measured in accordance with JIS K 7171. In this way, the photovoltaic power generation sheet 1 has flexibility, and thus it can follow a shape of the installation surface 3, and is less likely to flap in the wind or the like when installed.

### Back Sheet 11

The back sheet 11 protects a back surface of the power generation unit 7. That is, the back sheet 11 is a back surface protection layer. As shown in Fig. 2, the back sheet 11 is disposed on a side opposite to the light receiving surface of the photovoltaic power generation sheet 1. The back sheet 11 has barrier performance against water vapor and protective performance against external forces. The back sheet 11 may be translucent, but is not necessarily required to be translucent. The term "translucent" used here indicates that a light transmittance is 10% or more at a peak wavelength of light before incidence.

The back sheet 11 has flexibility. The Young's modulus of the back sheet 11 is preferably 2,400 MPa or more, and more preferably 3,000 MPa or more. Also, the Young's modulus of the back sheet 11 is preferably 4,200 MPa or less, and more preferably 2,100 MPa or less. Examples of a material of the back sheet 11 include, for example, synthetic resins such as a thermoplastic resin, a thermosetting resin, a general-purpose plastic, an engineering plastic, and a vinyl resin (for example, polyvinyl chloride). Further, for the material of the back sheet 11, in addition to the synthetic resins, a natural resin, a rubber, a metal, carbon, pulp, or the like may be used.

A thickness of the back sheet 11 is preferably 50 µm or more, and more preferably 100 µm or more. Also, the thickness of the back sheet 11 is preferably 2,000 µm or less, and more preferably 1,000 µm or less.

### Power generation unit 7

The power generation unit 7 generates electricity from sunlight using the photovoltaic effect. The power generation unit 7 has flexibility. Only one power generation unit 7 may be provided for one photovoltaic power generation sheet 1, or the power generation unit 7 may be divided into a plurality of locations. In one power generation unit 7, a plurality of power generation cells 12 are arranged in one direction of surface directions of the photovoltaic power generation sheet 1 (a horizontal direction in Fig. 1, or a front and back direction on paper in Fig. 2(A)), and are monolithic. That is, the power generation unit 7 according to the present embodiment has a monolithic structure in which the plurality of power generation cells 12 form one module.

The power generation cell 12 is a photoelectric conversion element that utilizes the photovoltaic effect, and is the smallest unit element that can generate electricity. In the power generation unit 7 having a monolithic structure, the power generation cells 12 are mechanically joined together and electrically connected to each other. An amount of power generation in one power generation unit 7 can be changed by increasing or decreasing the number of power generation cells 12.

Each of the power generation cells 12 extends in one direction and is formed in a band shape. In the present embodiment, the longitudinal direction of the power generation cell 12 is parallel to the longitudinal direction of the photovoltaic power generation sheet 1. Each of the power generation cells 12 extends from one end portion of the photovoltaic power generation sheet 1 in the longitudinal direction to the other end portion. The maximum distance from an end face of the back sheet 11 to an end face of the power generation cell 12 is preferably 1.0 mm or more and 500 mm or less, more preferably 2.0 mm or more and 300 mm or less, and even more preferably 3.0 mm or more and 100 mm or less. The term "end portion of the photovoltaic power generation sheet 1" indicates a case in which the maximum distance from the end face of the back sheet 11 to the end face of the power generation cell 12 is 500 mm or less. In the present embodiment, as shown in Fig. 2(A), there is the sealing layer 18 between the end face of the back sheet 11 and the end face of the power generation cell 12, but the end face of the power generation cells 12 may be flush with the end face of the back sheet 11 and/or the end face of the barrier sheet 17.

A width of the power generation cells 12 is preferably 0.003% to 1.0% of the length of the power generation cells 12, more preferably 0.01% to 0.3%, and even more preferably 0.03% to 0.15%. Specifically, the width of the power generation cells 12 is preferably 1 mm or more and 10 mm or less, more preferably 1.5 mm or more and 7 mm or less, and even more preferably 2 mm or more and 5 mm or less.

As shown in Fig. 2(A), each of the power generation cells 12 includes a translucent substrate 13, a translucent conductive layer 14, a power generation layer 15, and an electrode 16. The translucent substrate 13, the translucent conductive layer 14, the power generation layer 15, and the electrode 16 are laminated in this order in a direction from the barrier sheet 17 toward the back sheet 11. That is, these layers are disposed so that the translucent substrate 13 faces the barrier sheet 17 and the electrode 16 faces the back sheet 11.

### Translucent Substrate 13

The translucent substrate 13 supports the translucent conductive layer 14, the power generation layer 15, and the electrode 16. The translucent substrate 13 has translucency. Although the translucency of the translucent substrate 13 may be set such that a light transmittance with respect to the peak wavelength of the light before incidence is 10% or more, the light transmittance is preferably 50% or more, and more preferably 80% or more. The term "transparent" here indicates having a light transmittance of 80% or more with respect to the peak wavelength of the light before incidence.

Examples of a material of the translucent substrate 13 include an inorganic material, an organic material, and a metal material. Examples of the inorganic material include quartz glass and alkali-free glass. Examples of the organic material include plastics such as polyethylene terephthalate (PET), polyethylene naphthalene (PEN), polyethylene, polyimide, polyamide, polyamideimide, a liquid crystal polymer, and a cycloolefin polymer, as well as polymer films. Examples of the metal material include stainless steel, aluminum, titanium, and silicon.

A thickness of the translucent substrate 13 is not particularly limited as long as it can support the translucent conductive layer 14, the power generation layer 15, and the electrodes 16, but may be, for example, 10 µm or more and 300 µm or less.

The translucent substrate 13 is a substrate required in a manufacturing process of the power generation cells 12. For this reason, it is not necessarily a configuration required for a product of the photovoltaic power generation sheet 1. For example, the translucent substrate 13 may be used only during the manufacturing process of the photovoltaic power generation sheet 1, or may be removed after or during manufacturing. Also, when the translucent substrate 13 is removed, a non-translucent substrate may be used instead of the translucent substrate 13.

### Translucent conductive layer 14

The translucent conductive layer 14 is a layer having electrical conductivity and functions as a cathode. The translucent conductive layer 14 has translucency. The translucent conductive layer 14 is preferably transparent.

Examples of a material of the translucent conductive layer 14 include transparent materials such as an indium tin oxide (ITO), an F-doped tin oxide (FTO), and a Nesa film. The translucent conductive layer 14 is formed on a surface of the translucent substrate 13 by, for example, sputtering, ion plating, plating, coating, or the like.

Also, the translucent conductive layer 14 may be configured to have translucency by forming a pattern that can transmit light, while using a non-translucent material. Examples of the non-translucent material include, for example, platinum, gold, silver, copper, aluminum, rhodium, indium, titanium, nickel, tin, zinc, alloys containing these, and the like. Examples of the pattern that can transmit light include lattice, line, wavy line, honeycomb, and round hole patterns, and the like.

A thickness of the translucent conductive layer 14 is preferably, for example, 30 nm or more and 300 nm or less. When the translucent conductive layer 14 is 30 nm or greater and 300 nm or less, good conductivity can be obtained while maintaining high flexibility.

### Power generation layer 15

The power generation layer 15 is a layer that causes photoelectric conversion by being irradiated with light, and generates electrons and holes from excitons generated by absorbing light. As shown in Fig. 2(B), the power generation layer 15 includes a hole transport layer 151, a photoelectric conversion layer 152, and an electron transport layer 153. The hole transport layer 151, the photoelectric conversion layer 152, and the electron transport layer 153 are laminated in this order in a direction from the translucent conductive layer 14 toward the electrode 16.

### Hole transport layer 151

The hole transport layer 151 extracts holes generated in the photoelectric conversion layer 152 to the translucent conductive layer 14, and prevents electrons generated in the photoelectric conversion layer 152 from moving to the translucent conductive layer 14. For example, a metal oxide can be used for a material of the hole transport layer 151. Examples of the metal oxide include a titanium oxide, a molybdenum oxide, a vanadium oxide, a zinc oxide, a nickel oxide, a lithium oxide, a calcium oxide, a cesium oxide, an aluminum oxide, and the like. Further, in addition thereto, a delafossite type compound semiconductor (CuGaO₂), a copper oxide, a copper thiocyanate (CuSCN), a vanadium pentoxide (V₂O₅), a graphene oxide, or the like may also be used. In addition, a p-type organic semiconductor or a p-type inorganic semiconductor can also be used for the material of the hole transport layer 151.

A thickness of the hole transport layer 151 is preferably, for example, 1 nm or more and 1,000 nm or less, more preferably, 10 nm or more and 500 nm or less, and even more preferably, 10 nm or more and 50 nm or less. If the thickness of the hole transport layer 151 is 1 nm to 1,000 nm, the transport of holes can be realized.

### Photoelectric conversion layer 152

The photoelectric conversion layer 152 (photoactive layer) is a layer that performs photoelectric conversion of absorbed light. A material of the photoelectric conversion layer 152 is not particularly limited as long as it can perform photoelectric conversion of the absorbed light, and for example, amorphous silicon, perovskite, non-silicon material (semiconductor material CIGS), or the like can be used. In addition, the photoelectric conversion layer 152 may also have a tandem type laminated structure that combines these materials. The photoelectric conversion layer 152 using a non-silicon material uses the semiconductor material CIGS containing copper (Cu), indium (In), gallium (Ga), and selenium (Se), which makes it easier to reduce a thickness of the photoelectric conversion layer 152.

A photoelectric conversion layer 152 using perovskite will be described below as an example of the photoelectric conversion layer 152. The photoelectric conversion layer 152 containing a perovskite compound has the advantage that the power generation efficiency has a relatively low dependency on an angle of incident light (hereinafter, sometimes referred to as incidence angle dependency). Thus, the photovoltaic power generation sheet 1 according to the present embodiment has a low incidence angle dependency, that is, has little dependency on a slope of the installation surface, and thus can be installed in a wider location than other solar cells. This allows for high power generation efficiency.

The perovskite compound is a structure having a perovskite crystal structure or a crystal similar thereto. The perovskite crystal structure is expressed by the composition formula ABX₃. In this composition formula, for example, A represents an organic cation, B represents a metal cation, and X represents a halogen anion. However, the A site, the B site, and the X site are not limited thereto.

An organic group of the organic cation that constitutes the A site is not particularly limited, and examples thereof include alkyl ammonium derivatives, formamidinium derivatives, and the like. The organic cation constituting the A site may be of one type or of two or more types.

A metal of the metal cation constituting the B site is not particularly limited, and examples thereof include Cu, Ni, Mn, Fe, Co, Pd, Ge, Sn, Pb, Eu, and the like. The metal cation constituting the B site may be of one type or of two or more types.

The halogen of the halogen anion constituting the X site is not particularly limited, and examples thereof include F, Cl, Br, I, and the like. The halogen anion constituting the X site may be of one type or of two or more types.

The thickness of the photoelectric conversion layer 152 is preferably, for example, 1 nm or more and 1,000,000 nm or less, more preferably 100 nm or more and 50,000 nm or less, and even more preferably 300 nm or more and 1,000 nm or less. If the thickness of the photoelectric conversion layer 152 is 1 nm or more and 1,000,000 nm or less, the photoelectric conversion efficiency is improved.

### Electron transport layer 153

The electron transport layer 153 extracts electrons generated in the photoelectric conversion layer 152 to the electrode 16, and prevents holes generated in the photoelectric conversion layer 152 from moving to the electrode 16. The electron transport layer 153 preferably contains, for example, either a halogen compound or a metal oxide.

Examples of the halogen compound include a lithium halide (LiF, LiCl, LiBr, or LiI) and a sodium halide (NaF, NaCl, NaBr, or NaI). Examples of elements constituting the metal oxide include titanium, molybdenum, vanadium, zinc, nickel, lithium, potassium, cesium, aluminum, niobium, tin, barium, and the like In addition, an n-type organic semiconductor or an n-type inorganic semiconductor can also be used for a material of the electron transport layer 153.

A thickness of the electron transport layer 153 is preferably, for example, 1 nm or more and 1,000 nm or less, more preferably, 10 nm or more and 500 nm or less, and even more preferably, 10 nm or more and 50 nm or less. If the thickness of the electron transport layer 153 is 1 nm or more and 1,000 nm or less, the transport of electrons can be realized.

The electrode 16 has conductivity and functions as an anode. The electrode 16 can extract electrons from the photoelectric conversion layer 152 in response to the photoelectric conversion caused by the photoelectric conversion layer 152. The electrode 16 may have translucency or may be configured by a non-translucent material. Examples of the material of the electrode 16 include platinum, gold, silver, copper, aluminum, rhodium, indium, titanium, nickel, tin, zinc, alloys containing these, and the like.

### Operations of power generation cells 12

When the power generation cells 12 are irradiated with light, the photoelectric conversion layer 152 of the power generation layer 15 absorbs the light and performs the photoelectric conversion, and thus the electrons and the holes are generated in the photoelectric conversion layer 152. The electrons are extracted to the electrode 16 (anode) via the electron transport layer 153, and the holes are extracted to the translucent conductive layer 14 (cathode) via the hole transport layer 151, whereby a current is drawn from the translucent conductive layer 14 and the electrode 16 (that is, power generation is performed).

### Joint structure of plurality of power generation cells 12, etc.

The power generation unit 7 is configured by mechanically joining and electrically connecting the plurality of power generation cells 12 in one direction. Here, Fig. 2(C) shows a cross-sectional view along line D-D in FIG. 2(A) (however, the sealing layer 18, the back sheet 11, and the barrier sheet 17 are omitted). As shown in Fig. 2(C), the electrode 16 (anode) of each of the power generation cells 12 has an extending portion 161 extending from a portion laminated on the electron transport layer 153. The extending portion 161 extends to the translucent conductive layer 14 of the adjacent power generation cell 12, and is mechanically joined and electrically connected to the translucent conductive layer 14 of the adjacent power generation cell 12. The adjacent power generation cells 12 are joined together by the extending portion 161, and thus the translucent conductive layer 14 at one end of the power generation unit 7 and the electrode 16 at the other end of the power generation unit 7 are electrically connected to each other.

The power generation unit 7 includes the plurality of power generation cells 12, and thus even if a malfunction occurs in some of the power generation cells 12, the amount of electricity extracted from the power generation unit 7 can be stabilized.

Also, although the electrode 16 has the extending portion 161, the translucent conductive layer 14 (cathode) may have the extending portion 161 extending to the adjacent electrode 16.

In addition, when the power generation unit 7 is provided with the translucent substrate 13, from the viewpoint of facilitating the manufacture of the power generation unit 7, as shown in Fig. 2(C), the translucent conductive layer 14, the power generation layer 15, and the electrode 16 of each of the power generation cells 12 are preferably supported by a common translucent substrate 13.

The photovoltaic power generation sheet 1 may include the plurality of power generation units 7. In this case, the plurality of power generation units 7 are disposed along one surface of the photovoltaic power generation sheet 1. The plurality of power generation units 7 are electrically connected to each other in series or in parallel. The plurality of power generation units 7 are electrically connected to each other by a power distribution line disposed between the back sheet 11 and the barrier sheet 17.

In the case of connecting the plurality of power generation units 7 in series, in the adjacent power generation units 7, the translucent conductive layer 14 at the end of one power generation unit 7 is connected to the electrode 16 at the end of the other power generation unit 7 via a power distribution line. In the case of connecting the plurality of power generation units 7 in parallel, in the adjacent power generation units 7, the translucent conductive layers 14 are connected to each other with a power distribution line and/or conductive tape, and the electrodes 16 are connected to each other with a power distribution line or the like.

In the photovoltaic power generation sheet 1, in the case of disposing the plurality of power generation units 7 in one direction, a distance between the adjacent power generation units 7 may be more than 0 mm, and is preferably 2 mm or more, more preferably 10 mm or more, and even more preferably 15 mm or more. Also, the distance between the adjacent power generation units 7 is preferably 100 mm or less, more preferably 50 mm or less, and even more preferably 20 mm or less.

### Barrier sheet 17

The barrier sheet 17 protects a surface of the power generation unit 7. That is, the barrier sheet 17 is a surface protection layer. The barrier sheet 17 is located on a side opposite to the back sheet 11 in the thickness direction of the photovoltaic power generation sheet 1. The barrier sheet 17 is translucent, and preferably transparent. The barrier sheet 17 has barrier performance against water vapor and protective performance against external forces.

The barrier sheet 17 has flexibility. The Young's modulus of the barrier sheet 17 is preferably 2,400 MPa or more, and more preferably 3,000 MPa or more. Also, the Young's modulus of the barrier sheet 17 is preferably 4,200 MPa or less, and more preferably 4,000 MPa or less. Examples of a material of the barrier sheet 17 include synthetic resins such as a thermoplastic resin, a thermosetting resins, a general-purpose plastic, an engineering plastic, and a vinyl resin (for example, polyvinyl chloride). Further, for the material of the barrier sheet 17, in addition to the synthetic resins, a natural resin, a rubber, a metal, carbon, pulp, or the like may be used.

Also, a thickness of the barrier sheet 17 is preferably 50 µm or more, and more preferably 100 µm or more. Further, the thickness of the barrier sheet 17 is preferably 2,000 µm or less, and more preferably 1,000 µm or less.

When the photovoltaic power generation sheet 1 is heated or cooled, an amount of thermal expansion and contraction of the barrier sheet 17 is preferably close to that of the back sheet 11. That is, a ratio of the thermal expansion coefficient of the barrier sheet 17 to that of the back sheet 11 is preferably 6.0 or less, more preferably 3.0 or less, and even more preferably 1.0 or less. On the other hand, a lower limit of the ratio of the thermal expansion coefficient of the barrier sheet 17 to that of the back sheet 11 is preferably 0.8 or more, more preferably 0.9 or more, and even more preferably 0.95 or more.

Thus, after installation, even if a temperature rises due to sunlight or drops in winter, the effect of thermal expansion of the photovoltaic power generation sheet 1 can be reduced. As a result, shear stresses occurring at an interface between the back sheet 11 and the sealing layer 18 and at an interface between the barrier sheet 17 and the sealing layer 18 can be reduced.

### Sealing layer 18

The sealing layer 18 is filled between the barrier sheet 17 and the back sheet 11 with the power generation unit 7 disposed between them. The power generation unit 7 is embedded in the sealing layer 18 and covered by the sealing layer 18. Accordingly, the sealing layer 18 prevents water from entering the power generation unit 7 from around the power generation unit 7. The sealing layer 18 is translucent and is preferably transparent. Also, the sealing layer 18 does not necessarily need to cover the entire power generation unit 7. For example, if a part of the power generation unit 7 is exposed from the sealing layer 18, the exposed part may be covered with the sealing edge material 19 or the like.

Examples of a material of the sealing layer 18 include ethylene vinyl acetate (EVA), polyolefin, butyl rubber, silicone resin, polyvinyl butyral, acrylic resin, polyisobutylene resin, SBS resin, SIBS resin, and epoxy resin.

A shear modulus of elasticity of the sealing layer 18 is preferably 0.01 or more and 500 MPa or less, more preferably 0.05 or more and 250 MPa or less, and even more preferably 0.1 or more and 100 MPa or less. In this way, the sealing layer 18 deforms in a surface direction, and can absorb a shear stress in the surface direction caused by thermal expansion and contraction due to a difference in temperature between the back sheet 11 and the barrier sheet 17. Thus, occurrence of peeling of the back sheet 11 and the barrier sheet 17 due to the shear stress caused by thermal expansion and contraction can be inhibited.

The back sheet 11 and the barrier sheet 17 are bonded via the sealing layer 18, and the adhesive strength is preferably 0.1 N/10 mm or more and 10 N/10 mm or less in a peel test. In particular, when the photovoltaic power generation sheet 1 is installed in a bent state, the shear stress generated in the photovoltaic power generation sheet 1 becomes larger, and thus by adopting the adhesive strength in the above range in the peel test, a long period peeling can be effectively inhibited. The peel test is conducted in accordance with JIS Z 0237.

From the viewpoint of enhancing the effect of inhibiting peeling, a thickness of the sealing layer 18 is preferably 10 um or more, more preferably 30 µm or more, and even more preferably 50 µm or more. On the other hand, the thickness of the sealing layer 18 is preferably 300 µm or less, more preferably 200 µm or less, and even more preferably 100 µm or less. By setting the thickness of the sealing layer 18 to 10 µm or more, it is possible to ensure sufficient allowance for the shear stress during thermal expansion and contraction. By setting the thickness of the sealing layer 18 to 300 µm or less, it is possible to reduce a weight of the photovoltaic power generation sheet 1, thereby improving workability and ease of installation.

### Sealing edge material 19

The sealing edge material 19 seals the entire length of the outer edge with the plurality of power generation units 7 and the sealing layer 18 disposed between the back sheet 11 and the barrier sheet 17. As shown in Fig. 2(A), the sealing edge material 19 has a first bonding portion 191, a second bonding portion 192, and a sealing portion 193 connecting the first bonding portion 191 to the second bonding portion 192. The first bonding portion 191 is bonded to a front surface (upper surface in the figure) of the barrier sheet 17. The second bonding portion 192 is bonded to a rear surface (lower surface in the figure) of the back sheet 11. The first bonding portion 191, the sealing portion 193, and the second bonding portion 192 are integrally formed.

Examples of a material of the sealing edge material 19 include a tape material made of butyl rubber, silicone rubber, or the like.

Also, in the present embodiment, the sealing edge material 19 is not necessarily required. For example, instead of the sealing edge material 19, an edge portion of the barrier sheet 17 may be bent toward the back sheet 11 and the bent tip may be joined to the back sheet 11. This makes the sealing edge material 19 unnecessary.

### Roof surface

The roof surface is an upper surface of a roof member, and is a surface that forms a roof of a building. The roof member is an uneven roof 31 on which the plurality of protruding portions 33 and recessed portions 32 extending in the water flow direction are repeatedly formed at intervals in the horizontal direction.

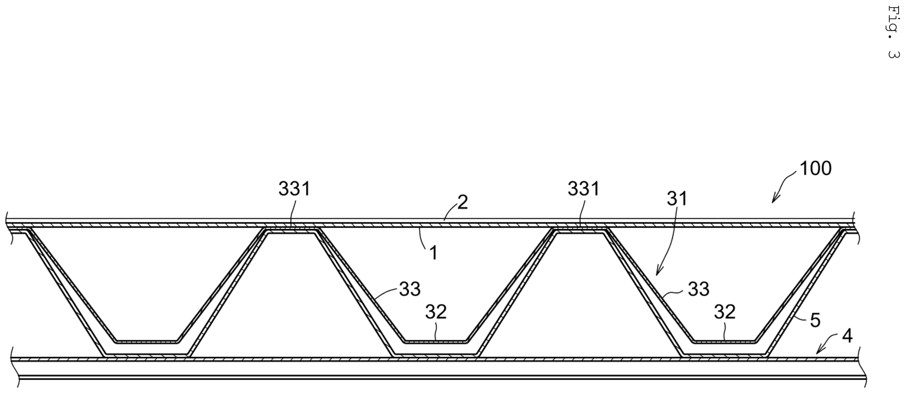

As shown in Fig. 3, the protruding portion 33 is formed in a shape that narrows toward the top portion 331 (inverted V-shaped cross-section). The top portion 331 of the protruding portion 33 is formed in a substantially flat shape. The shape of the protruding portion 33 does not necessarily have to be an inverted V-shaped cross-section, and may be, for example, a rectangular cross-section or a C-shaped cross-section.

The recessed portion 32 is the lowest part of the roof member in a cross-sectional view, and is located between adjacent protruding portions 33. In the present embodiment, the recessed portion 32 is formed in a substantially flat shape. However, the recessed portion 32 does not have to be flat. For example, if the uneven roof 31 is a corrugated slate, it is formed in a curved shape that protrudes downward.

The uneven roof 31 in the present embodiment is a folded plate roof. However, the uneven roof 31 may be, for example, a slate roof, a roof deck, a tile roof, a standing flat roof, or the like.

As shown in Fig. 1, the roof member is mounted to a cross member 4 via a plurality of tight frames 5. The cross member 4 is a horizontal member in a building, and is, for example, spanned between columns. Examples of the cross member 4 include beams (including main beams and small beams, for example), girders, purlins, and the like. The tight frames 5 are fixed to an upper surface of the cross member 4 and support the roof member. The plurality of tight frames 5 are disposed at intervals in the water flow direction.

An arithmetic mean roughness of the surface of the roof member is preferably 5 mm or less, more preferably 1 mm or less, and even more preferably 0.5 mm or less. On the other hand, the arithmetic mean roughness of the surface of the roof member is preferably 100 nm or more, more preferably 10 µm or more, and even more preferably 100 µm or more. By setting the surface roughness to 5 mm or less, a frictional force can be generated between the photovoltaic cell power generation sheet 1 and the installation surface 3, and thus it is possible to inhibit slippage in the surface direction and improve fixing strength. The arithmetic mean roughness is measured in accordance with JIS B 0601.

### Installation structure 100

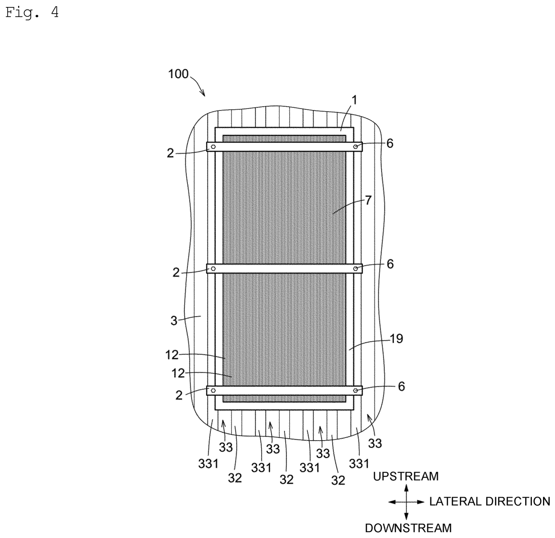

The photovoltaic power generation sheet 1 is mounted to the roof surface while remaining flat. As shown in Fig. 3, the photovoltaic power generation sheet 1 is disposed across the top portions 331 of the plurality of protruding portions 33, and is fixed to the roof surface by being pressed down from above by a plurality of mounting members 2. In the present embodiment, the photovoltaic power generation sheet 1 is disposed so that the longitudinal direction of the power generation cells 12 is parallel to the water flow direction, as shown in Fig. 4.

Each of the mounting members 2 is disposed so that its longitudinal direction intersects the longitudinal direction of the power generation cells 12. In the present embodiment, the longitudinal direction of each of the mounting members 2 is orthogonal to the longitudinal direction of the power generation cells 12, that is, parallel to the horizontal direction. As shown in Fig. 4, the mounting members 2 overlap the power generation unit 7 with the photovoltaic power generation sheet 1 pressed against the roof surface. In this way, in the present embodiment, even if the mounting members 2 overlap the power generation unit 7, not all of the power generation cells 12 are covered by the mounting members 2. As a result, regardless of positions of the mounting members 2 on the power generation cells 12 in the longitudinal direction, the mounting members 2 do not shade all the regions of each of the power generation cells 12 in the longitudinal direction at the same time, and thus when the monolithic power generation unit 7 having the band-shaped power generation cells 12 is mounted to the installation surface 3 using the mounting members 2, the power generation unit 7 can be firmly mounted while inhibiting a decrease in power generation efficiency.

The plurality of mounting members 2 are disposed at intervals in the water flow direction. Two of the plurality of mounting members 2 preferably press down longitudinal end portions of the photovoltaic power generation sheet 1. Also, the rest of the mounting members 2 of the plurality of mounting members 2 are preferably disposed between the mounting members 2 pressing down the end portions of the photovoltaic power generation sheet 1. Thus, it is possible to inhibit flapping of the photovoltaic power generation sheet 1 caused by the wind, and to inhibit a decrease in power generation efficiency while reducing damage.

The mounting member 2 is formed in an elongated shape extending in one direction. In the present embodiment, the mounting member 2 is formed in a flat plate shape. A width of the mounting member 2 is preferably constant in the longitudinal direction. The width of the mounting member 2 is preferably 2 mm or more, more preferably 3 mm or more, and even more preferably 5 mm or more. On the other hand, the width of the mounting member 2 is preferably 50 mm or less, more preferably 40 mm or less, and even more preferably 35 mm or less. By setting the width of the mounting member 2 to 2 mm or more, bending of the power generation unit 7 can be inhibited, and damage to the power generation unit 7 can be reduced. By setting the width of the mounting member 2 to 50 mm or less, the area of the power generation unit 7 covered by the mounting member 2 can be reduced, and power generation efficiency can be increased.

A thickness of the mounting member 2 is preferably thinner. The thickness of the mounting member 2 is preferably 1 mm or more, more preferably 2 mm or more, and even more preferably 3 mm or more. Also, the thickness of the mounting member 2 is preferably 20 mm or less, more preferably 15 mm or less, and even more preferably 10 mm or less. By setting the thickness of the mounting member 2 to 1 mm or less, flapping of the installed photovoltaic power generation sheet 1 can be reduced. By setting the thickness of the mounting member 2 to 20 mm or less, the shadow of the mounting member 2 overlapping the power generation unit 7 can be reduced.

The mounting member 2 is formed to be longer than a length of the photovoltaic power generation sheet 1 in the lateral direction. As shown in Fig. 1, the mounting member 2 is disposed so that a longitudinal direction of the mounting member 2 is aligned with the horizontal direction, and is mounted to upper surfaces of the top portions 331 of the protruding portions 33 to straddle the plurality of protruding portions 33. A portion of the mounting member 2 that protrudes from an edge of the photovoltaic power generation sheet 1 is fixed to the installation surface 3 by a fastener 6, thereby fixing the mounting member 2 to the installation surface 3. Examples of the fastener 6 include bolts and nuts, screws, rivets, pins, hook-and-loop fasteners, wire fasteners, double-sided tapes, and the like. Also, the mounting member 2 is not limited to being fixed to the roof surface by the fastener 6, but may be fixed by adhesive, welding, magnetic adhesion, or the like.

The mounting member 2 is preferably formed in a flat plate shape. This allows a contact area with the photovoltaic power generation sheet 1 to be widened. A contact surface of the mounting member 2 with the photovoltaic power generation sheet 1 is preferably provided with an anti-slip sheet.

In the flat plate-shaped contact surface of the mounting member 2, its corner portions (edges) that come into contact with the photovoltaic power generation sheet 1 are preferably chamfered by C-chamfering or R-chamfering. Thus, when an external force is applied vertically from the installation surface 3 to the contact portion between the photovoltaic power generation sheet 1 and the mounting member 2 due to wind or the like, concentration of a force applied from the mounting member 2 to the photovoltaic power generation sheet 1 can be inhibited, and damage to the photovoltaic power generation sheet 1 can be effectively inhibited. In particular, unlike a plate-shaped photovoltaic power generation device that is difficult to bend, deformation of the photovoltaic power generation sheet 1, which is likely to elastically deform, is difficult to predict, and thus it can be installed for a long period of time by dispersing a local force applied to the contact portion. As a similar method, a method for providing a spacer serving as an elastic member between the photovoltaic power generation sheet 1 and the mounting member 2 is also exemplified. The elastic member is not particularly specified, but examples thereof include a rubber, a soft resin, a metal washer, a torsion coil spring, leaf spring, and the like.

However, the mounting member 2 is not limited to a flat plate shape, and may be formed, for example, in a rod shape with a rectangular cross-section, a rod shape with a circular cross-section, a pipe shape, or a semicircular cross-section in which only the contact surface with the photovoltaic power generation sheet 1 is flat. In addition, although the mounting member 2 of the present embodiment is formed in a straight line shape, the mounting member 2 may adopt a shape such as a V-shape in a plan view, a Y-shape in a plan view, a Z-shape in a plan view, or an S-shape in a plan view, as long as the longitudinal direction of the mounting member 2 intersects the longitudinal direction of the power generation cells 12.

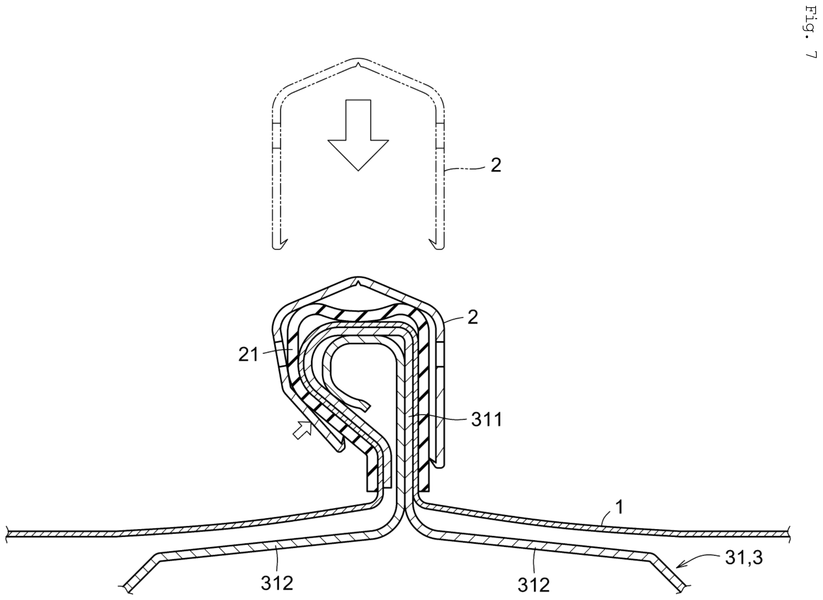

In particular, when the installation surface 3 has a protrusion 311, the shape of the mounting member 2 may be made in a shape that matches a shape of the protrusion 311. The protrusion 311 may be, for example, a seam fastening portion that connects the roof material 312 of the folded plate roof. In this case, the shape of the mounting member 2 may be, for example, a C-shaped cross-section, a U-shaped cross-section, or the like. Specifically, as shown in Fig. 7, the photovoltaic power generation sheet 1 is deformed along the protrusion 311, and then the mounting member 2 is pressed thereto from above, sandwiching the photovoltaic power generation sheet 1 between the protrusion 311 and the mounting member 2. The elongated mounting member 2 is disposed along a slope direction of the roof. With this configuration, the photovoltaic power generation sheet 1 can be easily pressed from above by the mounting member 2 and fixed to the installation surface 3, and thus the longitudinal direction of the mounting member 2 relative to the photovoltaic power generation sheet 1 can be appropriately adjusted simply by adjusting a position of the photovoltaic power generation sheet 1 relative to the installation surface 3.

Also, the mounting member 2 may be fitted simply by being pressed against the protrusion 311, or after being pressed, a part of the mounting member 2 may be deformed as shown by the arrow in Fig. 7. A gasket 21 may be disposed between the mounting member 2 and the photovoltaic power generation sheet 1. This reduces occurrence of damage to the photovoltaic power generation sheet 1. Further, when the plurality of power generation units 7 are disposed at intervals, the portion between the adjacent power generation units 7 may be sandwiched between the protrusion 311 and the mounting member 2. In this way, even if the mounting member 2 does not directly press the power generation units 7, the mounting member 2 can reduce the risk of shading all regions of any one power generation cell 12 at the same time.

The material of the mounting member 2 is not particularly limited, and examples thereof include, for example, a metal, a synthetic resin, carbon, rubber, cloth, leather, and the like. Examples of the metal include, for example, aluminum, SUS, and a painted metal member, and the like. Examples of the synthetic resin include, for example, a thermoplastic resin, a thermosetting resin, a general-purpose plastic, a composite reinforced material (engineering plastic), a vinyl resin (for example, polyvinyl chloride), and the like. Specific examples of the synthetic resin include, for example, polypropylene, polyethylene, rigid polyvinyl chloride, polycarbonate, polyamide, PPS, and the like. Examples of the composite reinforced material include, for example, those containing the above-mentioned synthetic resin with carbon, glass, and metal fibers.

A gap between the roof surface and the photovoltaic power generation sheet 1 is preferably as small as possible. With such a configuration, vibrations of the photovoltaic power generation sheet 1 can be more effectively reduced. A gap between the substantially V-shaped portion, which is formed by a slope of the protruding portion 33 and the recessed portion 32, and the photovoltaic power generation sheet 1 is preferably closed using a door member or the like. Also, a gap between the top portion 331 of the protruding portion 33 and the photovoltaic power generation sheet 1 is preferably filled with a joint material. Examples of the joint material include high-viscosity resins and cements. A viscosity of the joint material is preferably 0.1 Pa·s or more, and more preferably 10 Pa·s or more. The viscosity of the joint material is preferably 10,000 Pa·s or less, and more preferably 1,000 Pa·s or less. By setting the viscosity of the joint material to 0.1 Pa·s or more, the shape can be maintained not only in the surface direction but also in the vertical direction, and thus gaps can be effectively prevented. In addition, by setting the viscosity of the joint material to 10,000 Pa·s or less, the joint material can be easily spread when applied to the installation surface 3 or the back surface of the photovoltaic power generation sheet 1 at the time of fixing the photovoltaic power generation sheet 1, and thus it is possible to improve workability.

When the gap between the photovoltaic power generation sheet 1 and the installation surface 3 is sealed, the effect of inhibiting vibrations caused by wind or the like can be sufficiently obtained even if only the gap in a peripheral portion of the photovoltaic power generation sheet 1 is sealed. The term "peripheral portion" used here indicates a region from the end portion of the photovoltaic power generation sheet 1 toward its center in a direction along the installation surface 3 up to a certain distance. The certain distance is preferably 5 mm or more, more preferably 100 mm or more, and even more preferably 150 mm or more. On the other hand, the certain distance is preferably 250 mm or less, more preferably 200 mm or less, and even more preferably 175 mm or less. By sealing the gap between the photovoltaic power generation sheet 1 and the installation surface 3 at the peripheral portion, vibrations of the photovoltaic power generation sheet 1 can be appropriately inhibited, the joint material can be used efficiently, and a weight load on the installation surface 3 and so on can be reduced. For this reason, the photovoltaic power generation sheet 1 can be installed on an installation surface such as a fragile roof.

When only the gap of the peripheral portion of the photovoltaic power generation sheet 1 is sealed, a relatively airtight cavity that is closed off from the outside is generated between the photovoltaic power generation sheet 1 and the installation surface 3. In this case, air in the cavity expands and contracts due to a change in temperature, and thus a stress occurs in the vertical direction to the photovoltaic power generation sheet 1, which may damage the photovoltaic power generation sheet 1.

In order to inhibit this phenomenon, by making the joint material porous or providing air holes in the joint material, the photovoltaic power generation sheet 1 can be installed more stably. The total flow channel cross-sectional area of air holes is preferably 20 mm² or more, more preferably 25 mm² or more, and even more preferably 50 mm² or more. On the other hand, the total flow channel cross-sectional area of air holes is preferably 200 mm² or less, more preferably 150 mm² or less, and even more preferably 100 mm² or less. By setting the air holes so that the total flow channel cross-sectional area is 20 mm² or more, the air expanded and contracted due to a change in temperature can be appropriately exchanged with outside air, and a stress generated in the photovoltaic power generation sheet 1 can be reduced. In addition, by setting the air holes so that the total flow channel cross-sectional area is 200 mm² or less, it is possible to inhibit entrance of rainwater and to inhibit deterioration of the photovoltaic power generation sheet 1 due to the rainwater. From the viewpoint of waterproofing, the air holes are preferably provided on a lower side of the installation surface 3 in the slope direction, and more preferably face the lower side of the installation surface 3 in the slope direction.

If the gap between the outer peripheral portion of the photovoltaic power generation sheet 1 and the installation surface 3 is large and it is difficult to fill the gap with the above-mentioned joint material, a cover member made of, for example, a hard resin, a metal, ceramics, or the like may be provided at an end portion thereof.

### Effects

As described above, in the installation structure 100 for the photovoltaic power generation sheet 1 according to the present embodiment, the longitudinal direction of the elongated mounting member 2 intersects the longitudinal direction of the power generation cells 12, and thus regardless of the position of the mounting member 2 on the photovoltaic power generation sheet 1, the entire region of each of the power generation cells 12 in the longitudinal direction is not covered by the mounting member 2 at the same time. For this reason, when the photovoltaic power generation sheet 1 having the power generation unit 7 with the band-shaped power generation cells 12 is mounted to the installation surface 3 by the mounting member 2, it can be firmly fixed while inhibiting a decrease in power generation efficiency. In particular, the solar cell using organic compounds such as perovskite compounds have a property that a decrease in power generation efficiency is limited even if some of the power generation cells 12 in the longitudinal direction is covered, as compared to solar cells using inorganic compounds. For this reason, according to the installation structure 100 for the photovoltaic power generation sheet 1 according to the present embodiment, when the photovoltaic power generation sheet 1 is mounted to the installation surface 3 by the mounting member 2, a decrease in power generation efficiency can be further reduced.

Also, the installation surface 3 is a roof surface having a slope. In addition, the photovoltaic power generation sheet 1 is disposed so that the longitudinal direction of the power generation cells 12 is aligned with the water flow direction on the roof surface. For this reason, when the photovoltaic power generation sheet 1 is carried to the roof surface in a rolled-up state in the longitudinal direction and is installed on the roof surface, the photovoltaic power generation sheet 1 can be spread along the slope, which improves workability.

### Modified examples

The above embodiment is merely one of various embodiments of the present invention. Various modifications of the embodiment are possible depending on designs or the like as long as the object of the present invention can be achieved. Modified examples of the embodiment will be exemplified below. The modified examples described below can be applied in appropriate combination.

### First modified example

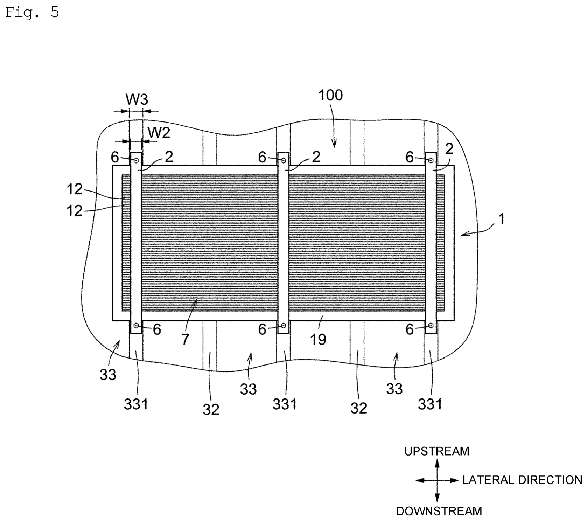

In the above embodiment, the photovoltaic power generation sheet 1 is disposed so that the longitudinal direction of the power generation cells 12 is parallel to the water flow direction, but as shown in Fig. 5, the photovoltaic power generation sheet 1 may be disposed so that the longitudinal direction of the power generation cells 12 is parallel to the horizontal direction. The photovoltaic power generation sheet 1 is disposed to straddle the plurality of protruding portions 33 in the horizontal direction.

The mounting member 2 is fixed to the roof surface so that the longitudinal direction of the mounting member 2 is parallel to the water flow direction. The mounting member 2 is fixed to the top portion 331 of the protruding portion 33 in a direction in which one protruding portion 33 extends. Accordingly, the photovoltaic power generation sheet 1 comes into contact with the mounting member 2 over the entire length in the water flow direction. Thus, the mounting member 2 can mount the photovoltaic power generation sheet 1 to the roof surface by pressing the longitudinal end portion of the photovoltaic power generation sheet 1 against the roof surface. The width W2 of the mounting member 2 is preferably equal to or smaller than the width W3 of the top portion 331 of the protruding portion 33.

In this way, when the photovoltaic power generation sheet 1 is disposed so that the longitudinal direction of the power generation cells 12 is parallel to the horizontal direction, even if streaky dirt occurs on the light receiving surface of the photovoltaic power generation sheet 1 in the water flow direction, the entire power generation cells 12 are not covered by the streaky dirt. As a result, even if streaky dirt appears on the light receiving surface of the photovoltaic power generation sheet 1 in the water flow direction, a decrease in power generation efficiency can be reduced.

In particular, when the water flow direction and the longitudinal direction of the mounting member 2 coincide with each other, accumulation of dirt on the mounting member 2 can be inhibited. Thus, occurrence of streaky dirt overlapping the power generation cells 12 of the photovoltaic power generation sheet 1 from the mounting member 2 can be inhibited, and dirt and dust accumulated on the surface of the photovoltaic power generation sheet 1 can be appropriately removed without performing cleaning work.

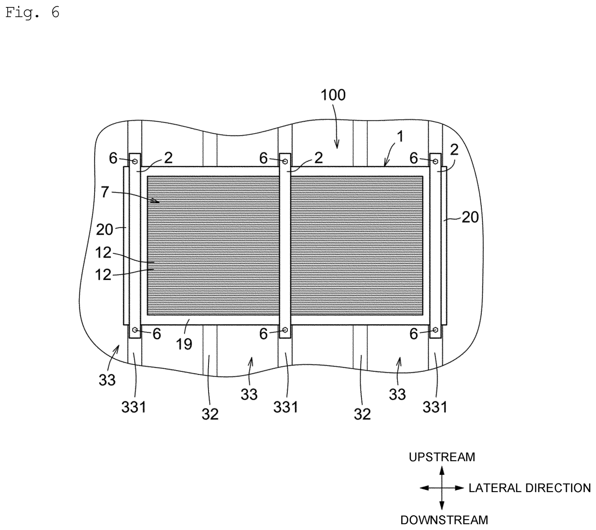

In the present modified example and the above embodiment, all the mounting members 2 overlap the power generation unit 7, but one mounting member 2 may overlap the power generation unit 7. For example, as shown in Fig. 6, regions 20 without the power generation unit 7 may be provided at both end portions of the photovoltaic power generation sheet 1 in the longitudinal direction, and the regions may be fixed with the mounting members 2. In addition, when a plurality of power generation units 7 are disposed at intervals in the longitudinal direction of the power generation cells 12, the mounting members 2 may press spaces between the adjacent power generation units 7.

### Other modified examples

In the case of the photovoltaic power generation sheet 1 having a photoelectric conversion layer 152 containing a perovskite compound, the power generation unit 7 can be easily designed without being limited to a rectangular shape. By utilizing this characteristic, the photovoltaic power generation sheet 1 can be shaped to match the shape of the installation surface 3. In the above embodiment, the photovoltaic power generation sheet 1 is rectangular in a plan view, but for example, if the installation surface 3 is fan-shaped in a plan view, the photovoltaic power generation sheet 1 may also be fan-shaped in a plan view. In this case, the longitudinal direction of the mounting member 2 may intersect the longitudinal direction of the power generation cells 12. The shape of the photovoltaic power generation sheet 1 is not limited to a fan shape, and may be, for example, a circle, an ellipse, a polygon, or the like.

The shortest distance between the end portion of the photovoltaic power generation sheet 1 and the power generation unit 7 is preferably 50 mm or less, more preferably 35 mm or less, and even more preferably 25 mm or less. In this way, by making the area of the power generation unit 7 as large as possible, the power generation efficiency can be improved. Further, by setting the shortest distance between the end portion of the photovoltaic power generation sheet 1 and the power generation unit 7 to 5 mm or more, more preferably 10 mm or more, and even more preferably 15 mm or more, water resistance of the photovoltaic power generation sheet 1 when used outdoors can be improved.

Also, a rod-shaped core member may be mounted to the end portion of the photovoltaic power generation sheet 1. The rod-shaped core member is preferably fixed to the end portion of the photovoltaic power generation sheet 1 so that its central axis is parallel to the lateral direction of the photovoltaic power generation sheet 1. When the rod-shaped core member is rotated around the central axis, the photovoltaic power generation sheet 1 is wound around the rod-shaped core member. For this reason, the photovoltaic power generation sheet 1 is in a rod shape rather than a sheet shape when transported, which improves portability. In addition, by winding the photovoltaic power generation sheet 1 around the rod-shaped core member after installation as well, the photovoltaic power generation sheet 1 can be temporarily removed from the installation surface 3 easily, and can also be easily reinstalled. This allows the photovoltaic power generation sheet 1 to be temporarily removed and stored during bad weather such as a storm. The rod-shaped core member may have any shape as long as the photovoltaic power generation sheet 1 can be wound around it, and may be hollow or solid, and may have a circular or polygonal cross-sectional shape. Also, a handle may be provided on the rod-shaped core member to rotate the rod-shaped core member using the handle. In addition, the power of a motor may be transmitted to the rod-shaped core member to rotate the rod-shaped core member using the motor.

A roll-up diameter of the rod-shaped core member is preferably 5 cm or more, more preferably 7.5 cm or more, and even more preferably 10 cm or more. The roll-up diameter of the rod-shaped core member is preferably 30 cm or less, more preferably 20 cm or less, and even more preferably 15 cm or less. By setting the roll-up diameter of the rod-shaped core member to 5 cm or more, damage to the photovoltaic power generation sheet 1 can be inhibited. By setting the roll-up diameter of the rod-shaped core member to 30 cm or less, it is easy to carry and install.

In the above-described embodiment, an aspect in which the back sheet 11 of the photovoltaic power generation sheet 1 is directly fixed to the installation surface 3 has been shown, but another sheet member may be interposed between the back sheet 11 and the installation surface 3. Examples of the sheet member include elastic sheets such as a synthetic resin sheet, a fiber-reinforced resin sheet, a rubber, and a composite sheet of resin, fiber, and metal. This can reduce misalignment of the photovoltaic power generation sheet 1.

When the photovoltaic power generation sheet 1 has a sheet member other than the back sheet 11 and the barrier sheet 17, the other sheet member may be pressed down by the mounting member 2. The other sheet member is connected to the back sheet 11 or the barrier sheet 17 by, for example, adhesion, fusion, or the like. The photovoltaic power generation sheet 1 is fixed to the installation surface by the other sheet member, and thus partial replacement is possible when a malfunction occurs in the power generation unit 7.

The sheet member is removably mounted to the installation surface 3. Thus, the photovoltaic power generation sheet 1 is removably fixed to the installation surface 3. As a fixing structure between the sheet member and the installation surface 3, at least one selected from the group consisting of hook-and-loop fasteners, magnets, double-sided tapes, adhesives, flange members, clamping members, hanging members, and frame members is used.

In the above embodiment, almost the entire mounting member 2 overlaps the power generation unit 7, but a configuration in which only a portion of the mounting member 2 overlaps the power generation unit 7 also falls within the category of the present invention as long as the longitudinal direction of the mounting member 2 intersects the longitudinal direction of the power generation cells 12.

In the photovoltaic power generation sheet 1 of the above embodiment, the longitudinal direction of the power generation cells 12 is parallel to the longitudinal direction of the photovoltaic power generation sheet 1, but the longitudinal direction of the power generation cells 12 may be parallel to the lateral direction of the photovoltaic power generation sheet 1.

In the above embodiment, the installation structure 100 in which the photovoltaic power generation sheet 1 is installed on the roof surface has been described, but the installation surface 3 is not limited to a roof surface, and can also be applied to, for example, wall materials (metal siding materials, ceramic siding materials, sandwich panels, and the like), partitions, door materials, fence materials, and the like.

In the above embodiment, a case in which the photovoltaic power generation sheet 1 has the photoelectric conversion layer 152 containing a perovskite compound has been described as an example, but in the present invention, any flexible photovoltaic power generation sheet 1 can achieve the same effect. Also, the photovoltaic power generation sheet 1 according to the present invention may be not only a solar cell that obtains the power generation effect from light, but also a sheet that converts light energy into another form of energy (light energy conversion sheet). Examples of the light energy conversion sheet include, in addition to the photovoltaic power generation sheet 1, a light generating sheet (sunlight-driven thermoelectric conversion device) that converts light energy into thermal energy.

### Description of Reference Numerals

100 Installation structure
1 Photovoltaic power generation sheet
12 Power generation cell
2 Mounting member
3 Installation surface
31 Uneven roof
32 Recessed portion
33 Protruding portion
7 Power generation unit

## Claims

1. An installation structure for a photovoltaic power generation sheet comprising:
a photovoltaic power generation sheet including a power generation unit in which a plurality of band-shaped power generation cells extending in one direction are arranged in a direction orthogonal to the one direction; and
an elongated mounting member configured to press down on the photovoltaic power generation sheet from above, thereby mounting the photovoltaic power generation sheet to an installation surface,
the mounting member being such that a longitudinal direction of the mounting member intersects a longitudinal direction of the power generation cells.

2. The installation structure for a photovoltaic power generation sheet according to claim 1, wherein
the installation surface is a roof surface having a slope, and
the photovoltaic power generation sheet is disposed so that the longitudinal direction of the power generation cells intersects a water flow direction on the roof surface.

3. The installation structure for a photovoltaic power generation sheet according to claim 2, wherein
the roof surface is included in an uneven roof configured so that protruding portions and recessed portions extending in the water flow direction are alternately arranged in a horizontal direction intersecting the water flow direction,
the photovoltaic power generation sheet is disposed so that the longitudinal direction of the power generation cells is aligned with the horizontal direction, and
the mounting member is disposed so that the longitudinal direction thereof is along at least one protruding portion of the plurality of protruding portions and is mounted to a top portion of the protruding portion.

4. The installation structure for a photovoltaic power generation sheet according to claim 1, wherein
the installation surface is a roof surface having a slope, and
the photovoltaic power generation sheet is disposed so that the longitudinal direction of the power generation cells is aligned with a water flow direction on the roof surface.

5. The installation structure for a photovoltaic power generation sheet according to claim 4, wherein
the installation surface is a roof surface of an uneven roof having a slope,
the uneven roof is configured so that protruding portions and recessed portions extending in the water flow direction are arranged alternately in a horizontal direction intersecting the water flow direction, and
the mounting member is disposed so that its longitudinal direction is aligned with the horizontal direction and is mounted to the protruding portions to straddle the plurality of protruding portions.

6. The installation structure for a photovoltaic power generation sheet according to any one of claims 1 to 5, wherein
the longitudinal direction of the power generation cells is parallel to a longitudinal direction of the photovoltaic power generation sheet.
